# EUROPÄISCHE PATENTSCHRIFT

(11) **EP 0 527 370 B1**
(45) Veröffentlichungstag und Bekanntmachung des Hinweises auf die Patenterteilung: **02.11.1995**
(21) Anmeldenummer: 92112672.8
(22) Anmeldetag: 24.07.1992
(51) Int. Cl.: H01J 37/317, G11B 9/00

(54) **Verfahren zur Durchführung ortsselektiver katalytischer Reaktionen mit oder auf Festkörperoberflächen im Nanometer- und Subnanometer-Bereich**
Procedure for implementing localised catalytic reactions with or on solid state surfaces on a nanometric or subnanometric scale
Procédé pour la mise en oeuvre de réactions catalytiques localisées avec ou sur des surfaces de corps solides à l'échelle nanométrique ou subnanométrique

(30) Priorität: 09.08.1991 DE 4126380
(43) Veröffentlichungstag der Anmeldung: 17.02.1993
(73) Patentinhaber: BASF Aktiengesellschaft, 67063 Ludwigshafen (DE)
(72) Erfinder: Fuchs, Harald, Dr., W-6719 Carlsberg (DE); Schimmel, Thomas, Dr., W-8670 Hof (DE)

(56) Entgegenhaltungen:
- EP-A- 0 427 443
- JOURNAL OF VACUUM SCIENCE AND TECHNOLOGY: PART A. Bd. 6, Nr. 2, April 1988, NEW YORK, US, Seiten 540 - 543; E.E. EHRICHS ET AL. 'Direct writing with the scanning tunnelling microscope.'
- JOURNAL OF VACUUM SCIENCE AND TECHNOLOGY: PART A. Bd. 8, Nr. 1, Februar 1990, NEW YORK, US, Seiten 667 - 671; R.H. BERNHARDT ET AL. 'Mechanisms for the deposition of nanometer-sized structures from organic fluids using the scanning tunnelling microscope.'
- IBM TECHNICAL DISCLOSURE BULLETIN. Bd. 29, Nr. 6, November 1986, NEW YORK, US, Seiten 2680 - 2681; 'Direct pattern writing by local heating in a scanning tunneling microscope.'

## Beschreibung

Die Erfindung betrifft ein Verfahren zur Durchführung ortsselektiver katalytischer Reaktionen mit oder auf Festkörperoberflächen im Nanometer- und Subnanometer-Bereich, wobei die betreffende Oberfläche lokal chemisch modifiziert wird sowie die Verwendung dieses Verfaharens zur Informationsspeicherung.

Die kontrollierte, ortsselektive Durchführung katalytischer Reaktionen an Oberflächen auf möglichst kleiner Längenskala und an möglichst genau definierten Positionen der Oberfläche ist in mehrfacher Hinsicht von Interesse.

Zum einen ist eine definierte chemische Veränderung von Festkörperoberflächen mit höchster Ortsauflösung gerade in der Bauelementefertigung in der Halbleiterindustrie zu einer Schlüsseltechnologie geworden, die über eine potentielle weitere Miniaturisierung der Bauteile und deren Grenzen entscheidet. Hier sind der Ortsauflösung bei den konventionellen lithographischen Prozessen bereits durch die Wellenlänge der verwendeten Strahlung prinzipielle Grenzen gesetzt. Auf der anderen Seite zeigen Experimente mit dem Rastertunnelmikroskop, daß es möglich ist, Materie auf der Skala von Nanometern und sogar auf atomarer Skala definiert zu verändern. Oberflächensensitive Rastersonden stellen hier also eine Technik bereit, die eine Ortsauflösung erlaubt, wie sie mit konventionellen Methoden der Halbleiterfertigung bislang nicht erzielt werden konnte.

Zum anderen läßt sich die kontrollierte chemische Modifikation von Oberflächen auf einer Skala von wenigen Nanometern bis hin zu atomaren Dimensionen auch zur Informationsspeicherung verwenden, etwa, indem man die Oberfläche in nanometergroße "Planquadrate" einteilt und einem unmodifizierten Planquadrat den Wert 0 und einem chemisch modifzierten Planquadrat den Wert 1 zu ordnet. Ist die chemische Reaktion zudem reversibel, lassen sich die so gespeicherten Informationen auch wieder löschen.

Voraussetzung für die Anwendung solcher Techniken ist allerdings die Bereitstellung eines Verfahrens, das eine solche lokale chemische Modifikation, etwa mit einer oberflächensensitiven Rastersonde, erlaubt. Bisher bekannt gewordene Versuche basieren meist auf einem reaktiven elektrochemischen Ätzen der Oberfläche, etwa der von Graphit (s. J.P. Rabe, S. Buchholz und A.M. Ritcey, J. Vac. Sci. Technol. A, 8 (1990) 679). Bei solchen Verfahren wird allerdings die Oberfläche irreversibel zerstört, was unter anderem eine "Löschbarkeit" in obigem Sinne ausschließt. Dieser prinzipielle Nachteil läßt sich vermeiden, wenn man die Struktur des atomaren oder molekularen Oberflächengitters intakt läßt und z.B. nur Fremdatome chemisch an die Oberfläche bindet. Solche "Labels" lassen sich dann durch Zufuhr von Energie, etwa in Form von thermischer Energie, wieder entfernen. Eine Möglichkeit zur praktischen Durchführung solcher und anderer lokaler chemischer Oberflächenreaktionen besteht im Einsatz eines Katalysators. Um zu vermeiden, daß dabei größere Bereiche der Oberfläche katalytisch reagieren, ist es aber wesentlich, daß der Katalysator nur lokal wirksam wird.

Aufgabe der vorliegenden Erfindung war es daher, ein Verfahren bereitzustellen, das eine gezielte und ortsselektive Durchführung katalytischer chemischer Reaktionen mit oder auf einer Oberfläche mit hoher Ortsauflösung bis in den Nanometerbereich bzw. bis in den atomaren Bereich erlaubt.

Es wurde nun gefunden, daß sich die Aufgabe mit einem Verfahren zur gezielten und ortsselektiven Durchführung katalytischer chemischer Reaktionen mit oder auf einer Festkörperoberfläche im Nanometer- und Subnanometerbereich lösen läßt, wenn als Katalysator eine das katalytische Material aufweisende oberflächensensitive Rastersonde verwendet wird, die sich während der Reaktion unmittelbar über dem Teil der Festkörperoberfläche befindet mit oder auf der die chemische Reaktion erfolgt.

Als oberflächensensitive Sonden lassen sich die Spitze eines Rastertunnelmikroskops (RTM) oder die Spitze des Levers eines Raster-Kraftmikroskops (RKM) heranziehen, wobei diese Sonden insbesondere aus einem katalytisch aktiven Material gefertigt oder mit ihm beschichtet sind. Als entsprechende Materialien seinen beispielhaft Platin/Iridium, Kobalt, Nickel und/oder Eisen genannt.

Geeignete Festkörperoberflächen sind halbleitende Schichtmaterialien, insbesondere Wolframdiselenid. In gleicher Weise können auch Festkörperoberflächen mit einer auf ihr befindlichen Adsorbatschicht oder einer flüssigkristalllinen Phase herangezogen werden.

Das erfindungsgemäße Verfahren läßt sich vorteilhaft so ausgestalten, daß die lokale chemische Reaktion der Oberfläche durch Zufuhr eines Gases als Reaktionspartner erfolgt, das auf die Oberfläche geblasen wird, nachdem die katalytisch aktive oberflächensensitive Rastersonde unmittelbar an der Stelle positioniert wurde, an der die Reaktion des Gases auf oder mit der Oberfläche erfolgen soll, wobei die katalytisch induzierte Reaktion des Gases mit der Oberfläche nur in der unmittelbaren Umgebung der katalytisch aktiven Sonde stattfindet und jeweils nach erfolgter lokaler Reaktion das überschüssige Gas entfernt wird. Dieses Vorgehen läßt sich nach erfolgter neuer Positionierung der Sonde an anderer Stelle der Festkörperoberfläche durch erneuten Gaseinlap wiederholen. Durch ein solches Vorgehen lassen sich auch atomare Positionen einer Festkörperoberfläche durch ortsselektive katalytische chemische Reaktion eines Gasatoms oder Gasmoleküls mit den an diesen Positionen befindlichen Atomen des Festkörpers markieren.

Eine weitere zweckmäßige Ausgestaltung des erfindungsgemäßen Verfahrens besteht darin, daß das Reaktionsgas vor der ortsselektiven katalytischen Reaktion bereits auf der Festkörperoberfläche oder auch der katalytisch aktiven Sonde adsorbiert oder chemisorbiert vorliegt.

In gleicher Weise eignet sich das erfindungsgemäße Verfahren zur Durchführung ortsselektiver katalytischer Reaktionen auch für den Fall, daß eine Reaktion zwischen der Festkörperoberfläche und einer Flüssigkeit, einem Flüssigkeitsfilm oder einer dünneren Adsorbatschicht initiiert werden soll.

Da sich während des Abbildungsprozesses, d.h. während die Festkörperoberfläche mit der oberflächensensitiven Rastersonde mit einer im Nanometerbereich oder im atomaren Bereich liegenden Auflösung abgebildet wird, die katalytisch aktive Sonde bereits in sehr dic-htem Abstand, in der Größenordnung von Atomdurchmessern, über der Oberfläche bewegt, ist es während der Abbildung der Oberfläche erforderlich, einen für den Ablauf der Reaktion erforderlichen Parameter, wie Temperatur, Abstand, Katalysator-Oberfläche, Einstrahlung von Licht, elektrisches Feld, Anwesenheit eines bestimmten Reaktionspartners, so zu wählen, daß nicht bereits während des Abbildungsvorganges die Reaktion überall dort abläuft, wo die Sonde mit der Probe in Kontakt kommt, wenn man auf einen solchen Abbildungsprozess nicht verzichten will.

Anschließend wird die chemisch zu modifizierende Stelle oder die Stelle, an der die katalytische Reaktion stattfinden soll, auf der Probenoberfläche ausgewählt und die Sonde an dieser Stelle positioniert und in hinreichend niedrigen Abstand zur Oberfläche gebracht. Nach erfolgter Positionierung der Sonde wird dafür Sorge getragen, daß alle Reaktionsparameter auf die für den Ablauf der Reaktion notwendigen Werte gebracht werden. Die Parameter werden dabei so eingestellt, daß die Reaktion nur an der Stelle des Sonde-Oberfläche-Kontaktes in nennenswertem Umfang stattfindet. In der Regel werden auch während dieses Abbildungsvorganges alle Reaktionsparameter bis auf einen auf diesen Werten gehalten, während dieser eine Parameter, der Auslöseparameter, erst nach Positionierung der Sonde auf einen für den Ablauf der lokalen chemischen Reaktion nötigen Wert gebracht wird. Als entsprechende Auslöseparameter kommen Temperatur, Konzentration des Reaktionsgases oder ein elektrisches, magnetisches oder elektromagnetisches Feld in Frage. Sofern die Reaktion erst bei erhöhter Temperatur mit nennenswerter Geschwindigkeit stattfindet, wird bei dem erfindungsgemäßen Verfahren die Temperatur lokal am gewünschten Ort der chemischen Reaktion durch kurzzeitige Anwendung eines ausreichend hohen elektrischen Stromes zwischen der oberflächensensitiven Rastersonde und der Probe, z.B. mit Hilfe eines Tunnelstromes bzw. eines Stromes durch einen Punktkontakt hervorgerufen. Auch läßt sich die katalytische Reaktion der Oberfläche am Ort der oberflächensensitiven Rastersonde durch ein transientes elektrisches Feld auslösen, wobei das transiente elektrische Feld durch Anwendung eines elektrischen Spannungspulses zwischen der katalytisch aktiven Rastersonde und der Oberfläche erzeugt wird. In einer weiteren vorteilhaften Ausgestaltung des erfindungsgemäßen Verfahrens wird die katalytische Reaktion der Oberfläche am Ort der oberflächensensitiven Rastersonde durch Einstrahlung von elektromagnetischer Strahlung, z.B. Laserstrahl, Mikrowellen, Infrarotstrahlung, Licht oder ultraviolette Strahlung, ausgelöst, wobei die Reaktion dadurch derart ortsselektiv durchgeführt werden kann, daß sie nur in unmittelbarer Umgebung der katalytisch aktiven Sonde stattfindet.

Generell gilt, daß das erfindungsgemäße Verfahren der ortsselektiven katalytischen Reaktion auch mittels einer Kombination der genannten Auslöseparameter vorgenommen werden kann, z.B. durch gleichzeitiges Spannungspulsen und lokales Heizen unter Anwesenheit der katalytisch aktiven Sonde und eines reaktiven Gases.

Unabhängig davon ist festzuhalten, daß sich das erfindungsgemäße Verfahren auch zur Auslösung solcher ortsselektiver katalytischer Reaktionen eignet, bei denen die chemische Oberflächenreaktion der Festkörperoberfläche ohne die Beteiligung oder Anwesenheit eines weiteren Reaktionspartners stattfindet.

Das erfindungsgemäße Verfahren weist den Vorteil auf, daß mit der gleichen Sonde, welche die chemischen Oberflächenveränderungen induziert, auch die Oberfläche vor und nach der Modifikation mit einer Ortsauflösung im Nanometer- oder Subnanometer-Bereich abgebildet werden kann. Diese hochauflösende Abbildung ist für die Prozeßkontrolle notwendig, sie läßt sich aber auch in besonders vorteilhafter Weise für die Speicherung von Informationseinheiten heranziehen. Damit wird ein Weg aufgezeigt, die Speicherung von Informationen im atomaren Bereich vorzunehmen und somit die entsprechend hohe Informationsdichte zu erreichen.

Die mit Hilfe des erfindungsgemäßen Verfahrens der ortsselektiven katalytischen Reaktion mit oder an einer Festkörperoberfläche vorgenommene Speicherung von Informationseinheiten läßt sich jedoch auch wieder löschen. Dies geschieht durch Zufuhr von Energie, etwa in Form thermischer Energie oder von elektromagnetischer Strahlung (z.B. flächige oder punktuelle Laserbehandlung), oder auch durch chemische Behandlung der Festkörperoberfläche. Auf diese Weise läßt sich der ursprüngliche Zustand wiederherstellen, da das Gitter während des Markierungsprozesses auch lokal nicht zerstört wurde.

Das erfindungsgemäße Verfahren sei im folgenden beispielhaft erläutert:

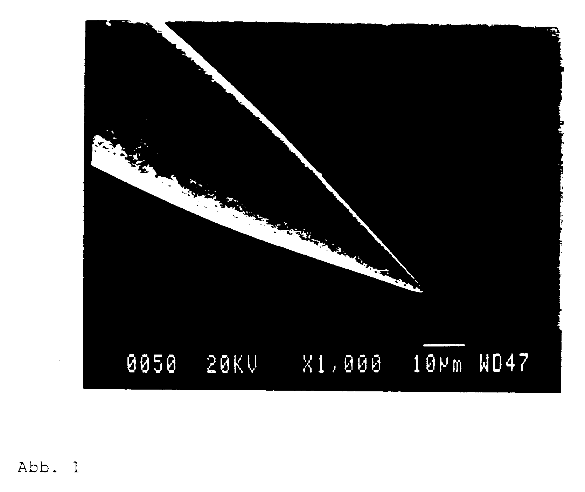

Als oberflächensensitive Rastersonde wurde die Spitze eines Raster-Tunnelmikroskops verwendet, die aus Pt-Ir als katalytisch aktivem Material besteht und durch mechanischen Schnitt aus Pt-Ir-Draht hergestellt wurde. Die Spitze wird dabei bis auf Abstände im Angstrom-Bereich (ein Angstrom = 10⁻¹⁰m) an die zu modifizierende Wolframdiselenid-Oberfläche, einen Schichthalbleiter, angenähert. Abb. 1 zeigt ein rasterelektronenmikroskopisches Bild der RTM-Spitze, die sich in unmittelbarer Nähe der Probenoberfläche befindet.

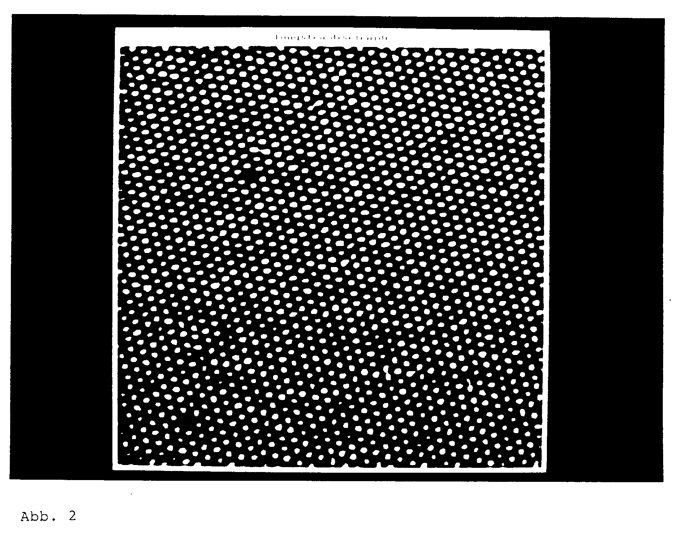

Vor der Oberflächenmodifikation wurde die Oberfläche mit atomarer Auflösung abgebildet (s. Abb. 2; die hellen Punkte sind die Atome, der interatomare Abstand beträgt 0.33 nm). Der Abbildungsvorgang wurde bei einer Tunnelspannung von 0.8 V durchgeführt, wobei die Spitze positiv gepolt war. Der Tunnelstrom betrug 3 nA. Der Abbildungsvorgang selbst führte auch nach mehrstündiger, ununterbrochener Abbildung des gleichen Bereichs der Probenoberfläche nicht zu einer Veränderung der Oberfläche. Dies gilt nicht nur für Untersuchungen im Vakuum (10⁻⁷ mbar), sondern auch, wenn der Abbildungsvorgang an Luft durchgeführt wird.

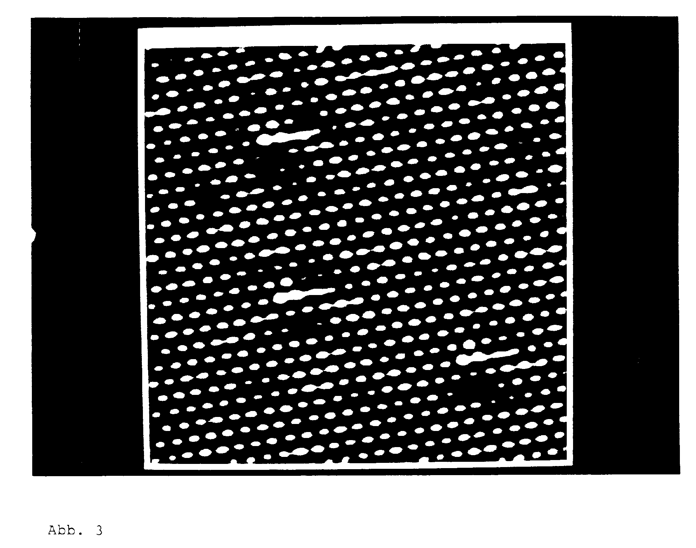

Die Oberflächenmodifikation wurde an Luft unter Normaldurck durchgeführt. Zum Auslösen der chemischen Reaktion der Oberfläche am Ort der Pt-Ir-Spitze wurde nun ein elektrischer Spannungspuls von 0.9 V Amplitude und 10 ms Dauer (Spitze positiv) zu der bestehenden Tunnelspannung addiert. Die dadurch bedingte kurzzeitige Erhöhung des Tunnelstromes führt auch zu einer kurzzeitigen lokalen Erwärmung der Spitze sowie der Probenoberfläche auf kleinster räumlicher Skala am Ort der Spitze. Der Puls löst an dem Ort, an den die Spitze positioniert ist, gezielt die gewünschte lokale Oberflächenveränderung aus, wie die anschließend mit der gleichen Spitze durchgeführte RTM-Abbildung (Abb. 3) zeigt. Jeder der hellen Stellen stellt eine solche Oberflächenmodifikation dar, die mit einem einzelnen Puls an der entsprechenden Stelle geschrieben wurde. Die Strukturen der Abb. 3 haben einen Durchmesser von ca. 1 nm.

Atomar aufgelöste Abbildungen der so modifizierten Oberflächen zeigen, daß die atomare Ordnung der Oberfläche nach dem Pulsen auch lokal am Ort der Modifikation unverändert erhalten bleibt und die Modifikation sich in einer Veränderung der effektiven Höhe ausdrückt, wie sie für eine lokale Veränderung der elektronischen Zustandsdichte typisch ist. Das atomare Gitter hingegen wird durch den Prozess nicht zerstört.

Es war dabei problemlos möglich, mehr als 100 solcher Modifikationen durchzuführen und anschließend abzubilden, ohne daß sich die Abbildungsqualität der Spitze oder ihre Wirksamkeit beim Schreibvorgang merklich verringerte. Auch zeigte sich, daß es trotz mehrerer hundert Abbildungsvorgänge ("Lesevorgänge" bei der Anwendung als Informationsspeicher) nicht zu einer Veränderung der modifizierten Bereiche kommt. Die Modifikationen erwiesen sich auch an Luft innerhalb der experimentellen Beobachtungsdauer von zwei Tagen als zeitstabil.

## Patentansprüche

1. Verfahren zur gezielten und ortsselektiven Durchführung katalytischer chemischer Reaktionen mit oder auf einer Festkörperoberfläche im Nanometer- und Subnanometerbereich, dadurch gekennzeichnet, daß als Katalysator eine das katalytische Material aufweisende oberflächensensitive Rastersonde verwendet wird, die sich während der Reaktion unmittelbar über dem Teil der Festkörperoberfläche befindet, mit oder auf dem die chemische Reaktion erfolgt.

2. Verfahren gemäß Anspruch 1, dadurch gekennzeichnet, daß als katalytisch aktive oberflächensensitive Sonde die Spitze eines Raster-Tunnelmikroskops (RTM) oder die Spitze des Levers eines Raster-Kraftmikroskops (RKM) eingesetzt wird.

3. Verfahren gemäß Anspruch 1 und 2, dadurch gekennzeichnet, daß die Sonde aus dem katalytisch aktiven Material gefertigt oder mit ihm beschichtet ist.

4. Verfahren gemäß Anspruch 1 und 2, dadurch gekennzeichnet, daß vor Durchführung der gezielten, ortsselektiven Oberflächenreaktion die Oberfläche mit der oberflächensensitiven Rastersonde mit einer im Nanometerbereich oder im atomaren Bereich liegenden Auflösung abgebildet wird und auf diese Weise die Spitze an ausgewählten Stellen der Oberfläche im Nanometer- bzw. Subnanometerbereich präzise positioniert werden kann.

5. Verfahren gemäß Anspruch 1 bis 4, dadurch gekennzeichnet, daß die lokale chemische Reaktion der Oberfläche durch Zufuhr eines Gases als Reaktionspartner erfolgt, das auf die Oberfläche geblasen wird, nachdem die katalytisch aktive oberflächensensitive Rastersonde unmittelbar an der Stelle positioniert wurde, an der die Reaktion des Gases mit der Oberfläche erfolgen soll, wobei die katalytisch induzierte Reaktion des Gases mit der Oberfläche nur in der unmittelbaren Umgebung der katalytisch aktiven Sonde stattfindet und jeweils nach erfolgter lokaler Reaktion das überschüssige Gas entfernt wird.

6. Verfahren gemäß Anspruch 1 bis 4, dadurch gekennzeichnet, daß die Reaktion erst bei erhöhter Temperatur mit nennenswerter Reaktionsgeschwindigkeit stattfindet und die erhöhte Temperatur lokal am gewünschten Ort der chemischen Reaktion durch kurzzeitige Anwendung eines ausreichend hohen elektrischen Stromes zwischen der oberflächensensitiven Rastersonde und der Probe hervorgerufen wird.

7. Verfahren gemäß Anspruch 1 bis 4, dadurch gekennzeichnet, daß die katalytische Reaktion der Oberfläche am Ort der oberflächensensitiven Rastersonde durch ein transientes elektrisches Feld ausgelöst wird.

8. Verfahren gemäß Anspruch 7, dadurch gekennzeichnet, daß das transiente elektrische Feld durch Anwendung eines elektrischen Spannungspulses zwischen der katalytisch aktiven Rastersonde und der Oberfläche erzeugt wird.

9. Verfahren gemäß Anspruch 1 bis 4, dadurch gekennzeichnet, daß die katalytische Reaktion der Oberfläche am Ort der oberflächensensitiven Rastersonde durch Einstrahlung von elektromagnetischer Strahlung ausgelöst wird.

10. Verfahren gemäß Anspruch 1, dadurch gekennzeichnet, daß die chemische Oberflächenreaktion der Festkörperoberfläche ohne die Beteiligung oder Anwesenheit eines weiteren Reaktionspartners stattfindet.

11. Verfahren gemäß Anspruch 1, dadurch gekennzeichnet, daß als Festkörperoberfläche ein halbleitendes Schichtmaterial eingesetzt wird.

12. Verfahren gemäß Anspruch 1, dadurch gekennzeichnet, daß als Festkörperoberfläche eine auf ihr befindliche Adsorbatschicht oder eine flüssigkristalline Phase verwendet wird.

13. Verfahren zur Beseitigung der gemäß einem der Ansprüche 1 bis 12 erhaltenen Markierungen durch Zufuhr thermischer Energie, Einwirkung elektromagnetischer Strahlung oder chemische Behandlung der Oberfläche.

14. Verwendung des Verfahrens zur gezielten lokalen katalytischen chemischen Modifikation der Oberfläche gemäß Anspruch 1 zur Speicherung von Informationseinheiten im Nanometer- und Subnanometer-Bereich.

15. Verwendung des Verfahrens gemäß Anspruch 13 zum Löschen von gemäß Anspruch 14 gespeicherten Informationseinheiten.

## Claims

1. A process for the specific and location-selective performance of catalytic chemical reactions with or on the surface of a solid in the nanometer or subnanometer range, which comprises using, as catalyst, a surface-sensitive scanning probe which contains the catalytic material and is located, during the reaction, directly above the part of the surface with which or on which the chemical reaction takes place.

2. A process as claimed in claim 1, wherein the catalytically active surface-sensitive probe employed is the tip of a scanning tunneling microscope (STM) or the tip of the lever of a scanning atomic force microscope (SAFM).

3. A process as claimed in claim 1 or 2, wherein the probe is made from or coated with the catalytically active material.

4. A process as claimed in claim 1 or 2, wherein, before the specific, location-selective surface reaction is carried out, the surface is imaged by means of the surface-sensitive scanning probe at a resolution in the nanometer range or in the atomic range, and in this way the tip can be positioned precisely at selected points on the surface in the nanometer or subnanometer range.

5. A process as claimed in claim 1 or 2 or 3 or 4, wherein the local chemical reaction of the surface is carried out by supplying a gas as reactant, the gas being blown onto the surface after the catalytically active surface-sensitive scanning probe has been positioned directly at the point at which the reaction of the gas with the surface is to take place, the catalytically induced reaction of the gas with the surface only occurring in the immediate vicinity of the catalytically active probe, and the excess gas being removed in each case when the local reaction is complete.

6. A process as claimed in claim 1 or 2 or 3 or 4, wherein the reaction only takes place at a significant reaction rate at elevated temperature, and the elevated temperature is brought about locally at the desired location of the chemical reaction by briefly applying an electrical current of sufficient magnitude between the surface-sensitive scanning probe and the sample.

7. A process as claimed in claim 1 or 2 or 3 or 4, wherein the catalytic reaction of the surface at the location of the surface-sensitive scanning probe is initiated by a transient electrical field.

8. A process as claimed in claim 7, wherein the transient electrical field is generated using an electrical voltage pulse between the catalytically active scanning probe and the surface.

9. A process as claimed in claim 1 or 2 or 3 or 4, wherein the catalytic reaction of the surface at the location of the surface-sensitive scanning probe is initiated by irradiation with electromagnetic radiation.

10. A process as claimed in claim 1, wherein the chemical surface reaction of the surface of the solid takes place without the participation or presence of a further reactant.

11. A process as claimed in claim 1, wherein the surface of the solid is a semiconducting layered material.

12. A process as claimed in claim 1, wherein the surface of the solid is an adsorbate layer present on the surface or is a liquid-crystalline phase.

13. A process for erasing the marks obtained as claimed in any one of claims 1 to 12 by supplying thermal energy, irradiation with electromagnetic radiation or chemical treatment of the surface.

14. The use of a process for the specific, local, catalytical chemical modification of a surface as claimed in claim 1 for storing information units in the nanometer or subnanometer range.

15. The use of a process as claimed in claim 13 for erasing information units stored as claimed in claim 14.

## Revendications

1. Procédé pour l'exécution sélective et localisée de réactions chimiques catalytiques avec ou sur la surface d'un corps solide à l'échelle nanométrique ou subnanométrique, caractérisé en ce que l'on utilise, comme catalyseur, une sonde à balayage à surface sensible qui comporte la matière catalytique et qui, pendant la réaction, se trouve immédiatement au-dessus de la partie de la surface du corps solide avec ou sur laquelle se produit la réaction chimique.

2. Procédé selon la revendication 1, caractérisé en ce que l'on utilise, comme sonde à activité catalytique à surface sensible, la pointe d'un microscope à effet tunnel à balayage (RTM) ou la pointe du levier d'un microscope à forces à balayage (RKM).

3. Procédé selon la revendication 1 ou 2, caractérisé en ce que la sonde est fabriquée en la matière à activité catalytique ou est revêtue de cette matière.

4. Procédé selon la revendication 1 ou 2, caractérisé en ce qu'avant l'exécution de la réaction superficielle sélective et localisée, une image est formée sur la surface avec la sonde à balayage à surface sensible, avec une résolution se situant à l'échelle nanométrique ou à l'échelle atomique et, de cette manière, la pointe peut être positionnée aux endroits sélectionnés de la surface avec une précision à l'échelle nanométrique ou subnanométrique.

5. Procédé selon l'une quelconque des revendications 1 à 4, caractérisé en ce que la réaction chimique locale de la surface se produit par apport d'un gaz qui constitue un partenaire réactionnel et qui est soufflé sur la surface, après que la sonde à balayage, catalytiquement active et à surface sensible, a été positionnée immédiatement à l'endroit où doit avoir lieu la réaction du gaz avec la surface, cette réaction du gaz avec la surface, induite catalytiquement, ne se produisant qu'au voisinage immédiat de la sonde à activité catalytique et le gaz en excès étant éliminé chaque fois après l'achèvement de la réaction locale.

6. Procédé selon l'une quelconque des revendications 1 à 4, caractérisé en ce que la réaction ne se produit à une vitesse appréciable qu'à température élevée, et en ce que la température élevée est produite localement, à l'endroit désiré de la réaction chimique, par la brève application d'un courant électrique suffisamment intense entre la sonde à balayage à surface sensible et l'échantillon.

7. Procédé selon l'une quelconque des revendications 1 à 4, caractérisé en ce que la réaction catalytique de la surface au niveau de la sonde à balayage à surface sensible est déclenchée par un champ électrique transitoire.

8. Procédé selon la revendication 7, caractérisé en ce que le champ électrique transitoire est créé par application d'une impulsion de tension électrique entre la sonde à balayage à activité catalytique et la surface.

9. Procédé selon l'une quelconque des revendications 1 à 4, caractérisé en ce que la réaction catalytique de la surface au niveau de la sonde à balayage à surface sensible est déclenchée par irradiation par un rayonnement électromagnétique.

10. Procédé selon la revendication 1, caractérisé en ce que la réaction chimique superficielle de la surface du corps solide se produit sans la participation ou la présence d'un autre partenaire réactionnel.

11. Procédé selon la revendication 1, caractérisé en ce qu'un matériau semiconducteur en couche est utilisé comme surface de corps solide.

12. Procédé selon la revendication 1, caractérisé en ce qu'il est utilisé, comme surface de corps solide, une couche d'adsorbat qui se trouve sur celui-ci ou une phase cristalline liquide.

13. Procédé pour la suppression des marques obtenues selon l'une quelconque des revendications 1 à 12, par l'apport d'énergie thermique, par l'action d'un rayonnement électromagnétique ou par un traitement chimique de la surface.

14. Utilisation du procédé de modification chimique catalytique, sélective et localisée, de la surface selon la revendication 1, pour la mémorisation d'unités d'information à i'échelle nanométrique ou subnanométrique.

15. Utilisation du procédé selon la revendication 13 pour l'effacement d'unités d'information mémorisées selon la revendication 14.
